Europäisches Patentamt

European Patent Office

Office européen des brevets

(11) Publication number: **0 598 475 A2**

# EUROPEAN PATENT APPLICATION

(21) Application number: **93307049.2**

(22) Date of filing: **07.09.93**

(51) Int. Cl.⁵: **H03K 19/003**, H03K 19/177

(30) Priority: **17.11.92 US 979167**

(43) Date of publication of application:
**25.05.94 Bulletin 94/21**

(84) Designated Contracting States:
**BE DE DK ES FR GB GR IE IT LU NL PT**

(71) Applicant: **ADVANCED MICRO DEVICES, INC.**
**901 Thompson Place**
**P.O. Box 3453**
**Sunnyvale, CA 94088(US)**

(72) Inventor: **Chang, Herman M.**
**10234 Miner Place**
**Cupertino, California 95014(US)**
Inventor: **Sharpe-Geisler, Bradley**
**1416 Dot Place**
**San Jose, California 95120(US)**

(74) Representative: **BROOKES & MARTIN**
**High Holborn House**
**52/54 High Holborn**
**London, WC1V 6SE (GB)**

(54) **Apparatus and method for protecting a programmable logic device from undesired input overshoot voltages.**

(57) A device for protecting a programmable logic device from undesired input overshoot voltages. The invention requires the overvoltage to be applied for a time duration longer than the predetermined time constant of a time delay circuit. The time delay distinguishes between the undesired overvoltages which are less than the predetermined time delay and are rejected as noise induced from the desired overvoltages which exceed the predetermined time delay and are recognized as intentional programming "super voltages". The invention is used to protect programmable logic devices, such as programmable arrays, from inadvertently entering into an erasable or programmable mode of the logic device, such as, the edit mode.

EP 0 598 475 A2

The present invention relates generally to an apparatus and method for improving the reliability of programmable logic devices by protecting the device from input overshoot voltages, and more, particularly, to improving the reliability of the functional operation and the integrity of programmable arrays in a noisy environment.

A programmable logic device normally requires a "super voltage" (i.e. >> $V_{DD}$, where $V_{DD}$ is the magnitude of the positive power supply voltage) ("programming voltage") to be input to one of the nodes in order to purposely trigger the programmable logic device to enter the "edit" mode. Entering the "edit" mode allows the programmable array to be erased or programmed.

During normal logic operations, the input terminals of the programmable logic device should only have voltages impressed that vary from Ground to $V_{DD}$. In a noisy environment, however, the input overshoot voltages can become large enough so that the "edit" mode is inadvertently triggered and the logic operation of the device is then disturbed. Accordingly, the edit mode may be inadvertently activated, thereby, erasing or programming the programmable logic device.

One problem, therefore, is how to provide protection from input overshoots and at the same time distinguish between an undesired overshoot voltage caused by noise and a desired programming voltage, both of which exceed the normal operating voltages of the device.

In the past, programmable logic devices have been completely unprotected from such excessive, frequently occurring input overshoots, and there is a need for such protection in a noisy operating environment.

Today, there is not available on the market an apparatus that adequately protects a programmable logic device from undesired, frequently occurring input overshoot voltages while reliably distinguishing programming overvoltages.

We will describe an arrangement to protect a programmable logic device from undesired input overshoot voltages by activating the edit mode of the logic devices only when an overvoltage is applied to the input for a time duration which is longer than a predetermined time delay.

We will describe a method and apparatus for protecting a programmable logic device from undesired input overshoot voltages which employs a circuit for detecting voltages above a preselected voltage level which is higher than $V_{DD}$, a circuit for activating a time delay circuit, a circuit for providing the time delay, and a circuit for activating the desired (edit) mode of the logic device.

We will describe an arrangement in which the time delay is used to distinguish an undesired input overshoot voltage from a desired input programming voltage.

We will describe an arrangement in which the desired mode of the logic device is activated only when a desired input programming voltage has been detected.

We will describe an arrangement in which the time delay circuit is not activated when normal operating voltages are applied to the input terminal of the device but is activated only during the presence of overvoltage inputs.

We will describe an arrangement in which the time delay circuit is deactivated when the input voltage of the device falls below the preselected voltage level, i.e. the input overvoltage level, and resetting that circuit for reactivation when the next overvoltage is received at the input.

Brief Description of the Drawings

Fig. 1 - Block Diagram of the Input Overshoot Protection Method For Programmable Logic Devices.

Fig. 2 - Schematic Diagram of the Input Overshoot Protection Device For Programmable Devices.

Detailed Description of the Invention

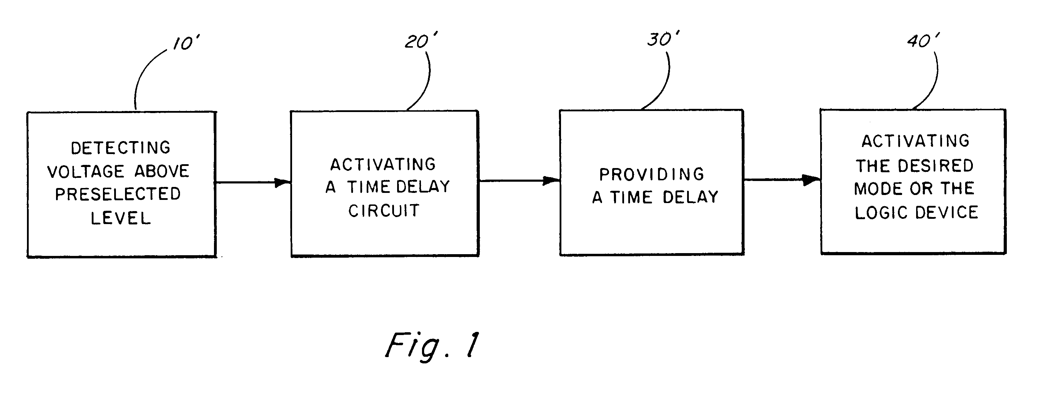

Figure 1 is a block diagram of the preferred method of an input overshoot protection for a programmable logic device. The method is comprised of four main steps: detecting voltages above normal operating voltages 10', a technique 20' for activating a time delay circuit, providing a time delay 30', and a switching method 40' for activating the desired (edit) mode of the logic device.

General Operation of the Device

A voltage is applied to the input terminal 11 of circuit 10 where it is determined whether this input voltage is above the preselected voltage level (which is higher than $V_{DD}$). If the input voltage is below the preselected voltage level, circuit 20 does not activate the time delay circuit 30, and circuit 40 will not activate the edit mode of the logic device.

Once a voltage above the preselected voltage level is applied to the input, it must then be determined whether the input overvoltage is a programming voltage that should be allowed to trigger the edit mode of the logic device or whether it is an overshoot voltage caused by noise which should not be allowed to trigger the desired (edit) mode of the logic.

Once an overvoltage is detected at the input of circuit 10, circuit 20 activates the time delay circuit 30. If the length of time during which the overvoltage is applied to the input of circuit 10 is longer than the predetermined time constant of the time delay circuit 30, then the overvoltage is deemed a desired programming voltage and the edit mode of the logic device is activated. If the duration of the overvoltage is less than a time period which is a function of the time constant of time delay circuit 30, the overvoltage is deemed an undesired overshoot voltage caused by noise and the edit mode of the logic device is not activated.

Moreover, when an overvoltage is no longer detected at the input of circuit 10, the edit mode of the logic device is deactivated if it were activated, and the time delay circuit 30 is also deactivated and reset to be ready for reactivation when the next overvoltage is detected.

## Detailed Description of the Operation of the Device

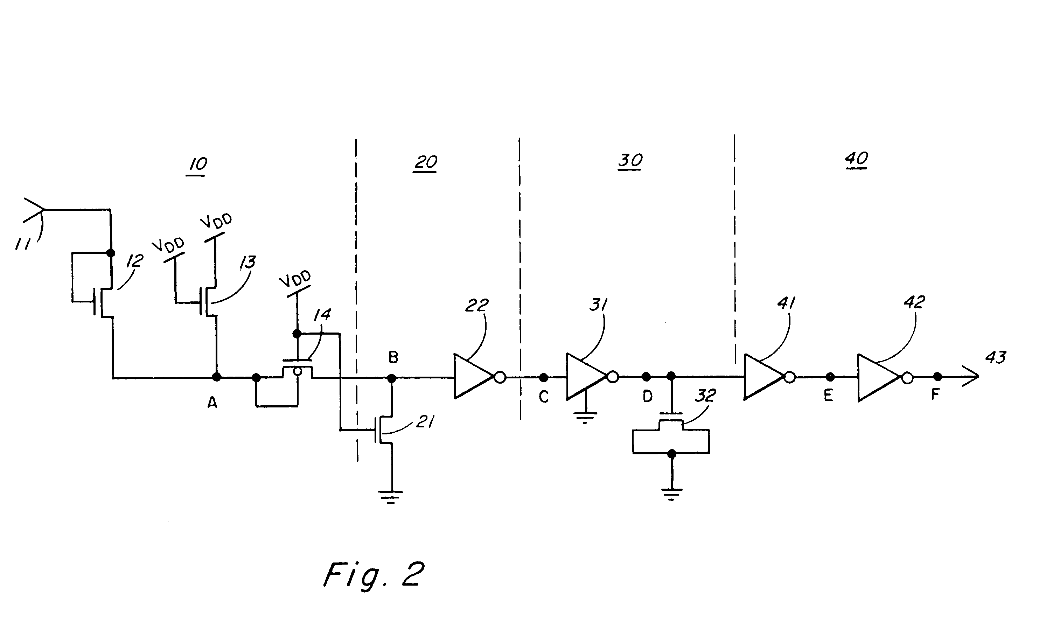

Figure 2 is a circuit diagram of a preferred embodiment of the inventive input overshoot protection device for a programmable logic device (now shown). As shown in Fig. 2, the device is divided into its four main circuits, and the circuit components are illustrated for each main circuit.

Circuit 10 detects voltages above a preselected voltage level. Such voltages are called overvoltages herein. Circuit 10, for detecting overvoltages, comprises field effect transistors 12, 13, and 14. The drain and gate of transistor 12 are connected together so that the transistor is functioning like a diode. The input voltage is received at input terminal 11, which is connected to the drain and gate of transistor 12. Terminal 11 is also connected to an input terminal of the programmable logic device. The drain and gate of transistor 13 are connected to the positive power supply voltage of the logic device, which is designated as $V_{DD}$, and transistor 13 also functions like a diode. The source of transistor 12 is connected to the source of transistor 13, which is shown as node A, and these two sources are connected to the source of transistor 14. The gate of transistor 14 is connected to $V_{DD}$ and the drain of transistor 14 is connected to node B. Transistor 14 is turned on only when an overvoltage is detected at terminal 11. Therefore, circuit 10 is activated <u>only</u> when an <u>overvoltage</u> is detected at its input i.e. greater than $V_{DD} + v_{tn} - v_{tp}$, where $V_{tn}$ is the threshold voltage of the N channel transistor 12, an $v_{t\,p}$ is the threshold voltage of the P channel transistor 14.

Circuit 20 for activating the time delay circuit comprises FET 21 and conventional MOSFET inverter 22. Transistor 21 functions as a "weak leaker" and is biased on by the application of $V_{DD}$ to its gate so that the input of inverter 22 is held at ground during normal input voltages. Transistor 21 is on during all phases of operation. However, transistor 12 and transistor 14 are sized to drive node B high when turned on when an overvoltage is applied to the input of the device even though transistor 21 provides a weak current path to ground. Thus, transistors 12 and 14 "overpower" transistor 21. As stated earlier, transistor 14 will be turned on when an overvoltage is applied to the input of circuit 10.

During the phase of the circuit operation in which an overvoltage is detected, transistor 14 will switch on to make the voltage at node B the same as the voltage at node A, and inverter 22 will be activated since the voltage at node B will be large enough to be a digital high signal ("high signal"). The voltage at node C would then become zero or a digital low signal ("low signal") to the time delay circuit 30 and this would cause cascade connected inverter 31 to turn on and to cause capacitor 32 to charge.

The time delay is provided by RC circuit 30 which comprises the inverter 31 and charging capacitor 32. Inverter 31 provides the resistance for the time delay when its voltage input goes to a low signal (i.e. a low input signal is needed to turn on inverter 31). The amount of resistance provided from inverter 31 and the value of the capacitor 32 determine the RC time constant of the circuit, and, therefore, the duration of the charging time delay.

If the duration of the overvoltage applied to the input terminal 11 exceeds the time delay of the delay circuit 30, the overvoltage is deemed an intentional programming voltage and circuit 40 will activate and provide a high signal to node E that will activate the edit mode. Circuit 40 comprises cascade connected inverter 41 and inverter 42 that will provide the desirable digital signal to terminal 43 which is connected to the edit node of the programmable logic device which will activate the edit mode of the programmable logic device.

Once the input voltage falls below the overvoltage level, the capacitor 32 is rapidly discharged through the circuit path which includes the drain, gate, and source of the N-channel transistor of inverter 31 to ground. If the desired mode of the programmable logic device were activated, it is then immediately deactivated. The time delay circuit has then been reset so that the proper time delay can be reactivated when the next overvoltage is detected.

## Modes of Operation

The following will apply to the example in describing the modes of operation of the present arrangement: transistors 12, 13, and 21 are N-channel MOSFETS, transistor 14 is a P-Channel MOSFET, inverters 22, 41, and 42 are typical digital logic gate inverters, inverter 31 is a digital logic gate inverter with a weak P-Channel transistor and a strong N-channel transistor, and Capacitor 32 is a large capacitor.

As is well known in the art, N-channel MOSFETs are activated when the voltage at the gate is at least one threshold voltage (i.e. $v_{tn}$) larger than the voltage at the source, and P-Channel MOSFET-(s) are activated when the voltage at the gate is at least one threshold voltage $V_{tp}$ smaller than the voltage at the source.

The following designations are also made for the purposes of this example: $V_{IN}$ = Input Voltage at terminal 11, $V_A$ = Voltage at node A, $V_B$ = Voltage at node B, $V_C$ = Voltage at node C, $V_D$ = Voltage at node D, $V_E$ = Voltage at node E, $V_F$ = Voltage at node F or Output Voltage at terminal 43. Also, a voltage at a terminal of a transistor will be designated by subscripting the terminal (D = Drain, S = Source, G = Gate) and the transistor (12, 13, 14, or 21) that is being referred to (i.e. The voltage at the Drain of transistor 12 will be designated $V_{D12}$).

In all phases of operation of the device, the drain and gate of transistor 13, the gate of transistor 14, and the power supply for all of the inverters are equal to the maximum normal operating voltage, $V_{DD}$. Also, in all phases of operation, there is a threshold voltage drop $v_{tn}$ across each of transistors 12 and transistor 13. This is because these two transistors are connected to operate like diodes.

During Normal Operation (Ground < $V_{IN}$ < $V_{DD}$)

During normal operations of the device, $V_A$ will equal $V_{DD} - v_{tn}$ since the largest voltage node A will see will be equal to $V_{S13}$ which is equal to $V_{DD} - v_{tn}$. Therefore, transistor 12 will be off since $V_{G12} - V_{S12} < v_{tn}$ and transistor 13 will be on since $V_{G13} - V_{S13} \geq v_{tn}$. The source of transistor 14 is connected to node A, and therefore, $V_{S14}$ will equal $V_{DD} - v_{tn}$ as well. So $V_{S14} = V_{DD} - V_{tn}$, where $V_{tn}$ is the threshold voltage of the N channel transistor and $V_{G14} = V_{DD}$. Therefore $V_{G14} - V_{S14} = V_{tn}$. Since transistor 14 is a P-Channel MOSFET, the source of transistor 14 must be connected to the N-well of the transistor. The reason for this is that the N-well must be tied to a voltage $\geq$ the source voltage. Otherwise, the source- N-well diode would forward bias and the P-channel transistor would not work properly. Transistor 21 is always on since $V_{G21} - V_{S21}$ is always greater than $v_{tn}$.

Transistor 21 will hold the input of inverter 22 to zero during the time of normal operation (i.e. $V_B$ will be a low signal). Since the drain of transistor 21 is connected to the input of inverter 22 at node B, $V_C$ will have a high signal (i.e. "on") and $V_D$ will be a low signal. The time delay circuit 30 will not be activated since $V_D$ is low, and this would not activate the charging of Capacitor 32. Also, $V_E$ will be a high signal and $V_F$ will be a low signal. The desired mode of the logic device will not be activated since the voltage of terminal 43 will receive a low signal (i.e. "off").

Operation when $V_{DD} < V_{IN} < V_{DD} + v_{tn} - v_{tp}$

When $V_{IN}$ is greater than $V_{DD}$ and less than $V_{DD} + v_{tn} - v_{tp}$, $V_A$ will equal $V_{IN} - v_{tn}$[1]since the largest voltage node A will see will be equal to $V_{S12}$ which is equal to $V_{IN} - v_{tn}$. Transistor 12 will turn on since $V_{G12} - V_{S12} \geq v_{tn}$, and transistor 13 will turn off since $V_{G13} - V_{S13} < v_{tn}$. Transistor 14 will still be off since $V_{G14} - V_{S14} = V_{tn} + (V_{DD} - V_{IN}) > V_{tp}$. Circuit 20 will not activate the time delay circuit 30, and the desired mode of the logic device will still not be activated for the same reasons as stated above for the normal operations of the device.

Operation when $V_{IN} \geq (V_{DD} + v_{tn} - v_{tp})$

When $V_{IN}$ is greater than or equal to $V_{DD} + v_{tn} - v_{tp}$, $V_A$ will equal $V_{IN} - v_{tn}$ since the largest voltage node A will see will be equal to $V_{S12}$ which is equal to $V_{IN} - v_{tn}$. Therefore, $V_A$ will either be equal to or greater than $V_{DD} - v_{tp}$. Transistor 12 will still be on since $V_{G12} - V_{S12} \geq v_{tn}$, and transistor 13 will still be off since $V_{G13} - V_{S13} < v_{tn}$.

Transistor 14, however, will turn on since $V_{G14} - V_{S14} = V_{DD} - (V_{IN} - V_{tn}) = V_{tn} + (V_{DD} - V_{IN}) \leq V_{tp}$. Transistor 12 and transistor 14 are both stronger than the weak leaker transistor 21, and transistors 12 and 14 when both turned on provide sufficient current to overcome the effect of transistor 21.

Transistor 14 is switched on such that the voltage at node B will be equal to $V_A$, which will equal $V_{DD} - v_{tp}$, which is recognized by inverter 22 as a high signal. (The inverters employed would typically recognize a voltage of $V_{DD}/2$ or larger as a digital high signal). A typical value for $V_{DD}$ is 5 volts, and a typical value for $v_{tp}$ is -1 volt for a P-channel MOSFET and for $v_{tn}$ is +1 volt for an N-channel MOSFET. Inverter 22 drives $V_C$ low, and inverter 31 drives $V_D$ high.

The time delay circuit 30, which is one of the novel features of this invention, is activated as the signal on node C goes low. Circuit 30 is comprised of the turn on resistance of the P-channel transistor of CMOS inverter 31 and capacitor 32. The P-

---

[1]$V_A = V_{IN} - v_{tn} = V_{S14}$; $V_{G14} = V_{DD}$. Therefore, $V_{G14} - V_{S14} = V_{DD} - (V_{In} - v_{tn}) = V_{tn} + (V_{DD} - V_{IN}) > V_{tp}$. However, $V_{G14} - V_{S14} = V_{tn} + (V_{DD} - V_{IN}) > V_{t\ p}$. The above inequality is true by the hypothesis that $V_{DD} < V_{IN} < V_{DD} + v_{tn} - v_{tp}$ since $V_{tn} + (V_{DD} - V_{IN}) > V_{tp}$ is equivalent to $V_{tn} - V_{tp} + V_{DD} > V_{IN}$.

channel transistor of inverter 31 is very weak compared to the N-channel transistor of inverter 31. Capacitor 32 is a very large capacitor. The time delay which circuit 30 would provide is determined by the strength of the P-channel transistor which is directly related to the turn on resistance of the P-channel transistor and the size of the capacitor. Dimensions for a typical capacitor would be 40 microns by 40 microns or approximately 3.2 picofarads, and a typical time delay provided by circuit 30 would be 250 nanoseconds.

Once $V_C$ becomes a low signal, the capacitor 32 begins to charge. If capacitor 32 does not charge to a level higher than the trip level of inverter 41, then this means that the input overvoltage was shorter in duration than the time delay provided by circuit 30 and is deemed an undesired input overshoot voltage caused by noise, and circuit 40 does not activate the desired mode of the logic device because capacitor 32 would discharge through the circuit path including the N-channel device of inverter 31, and the input of inverter 41 would be kept low. Capacitor 32 begins to discharge because the output terminal of inverter 31 to which it is connected is grounded by the turning on of the N-channel device and the turning off of the P-channel transistor of inverter 31. It is desirable that capacitor 32 completely discharge before the next overshoot voltage is received on input node 11.

If, on the other hand, capacitor 32 does charge to a level higher than the trip level of inverter 41 then this means that the input overvoltage was longer in duration than the time delay provided by circuit 30 and is recognized as an intentional programming voltage, and circuit 40 activates the edit mode of the logic device. The input of inverter 41 then becomes high because there will be a high voltage at node D.

The output of inverter 41, the voltage at node E, $V_E$, will be low, and the output of inverter 42, the voltage at node F, $V_F$, goes high. This high signal is applied to terminal 43, which is connected to the edit node of the programmable logic device, and will turn on the edit mode of the logic device. Inverters 41 and 42 are used because the voltage at node D may vary during the time when capacitor 32 is charging, and these inverters provide a discrete high or low signal to terminal 43 which ensures that terminal 43 will not be triggered at an improper voltage level.

### Operation when $V_{IN}$ is Suddenly Less Than ($V_{DD}$ + $v_{tn}$ - $v_{tp}$)

After capacitor 32 is charged to a level higher than the trip level of inverter 41, $V_{IN}$ may suddenly be less than $V_{DD}$ + $v_{tn}$ - $v_{tp}$. When this happens,

transistor 14 will turn off, and the input of inverter 22 (i.e. $V_B$) and the output of inverter 31 (i.e. $V_D$) will go low.

Capacitor 32 will rapidly discharge because the now on N-channel transistor of inverter 31 is so much stronger than the P-channel transistor of inverter 31. The voltage at node D, $V_D$, becomes O and circuit 40 will deactivate the desired mode of the logic device (i.e. turn off the "edit" mode of the programmable logic device).

Capacitor 32 is discharged completely to reset time delay circuit 30. The entire protection device is then ready to receive the next overvoltage input.

### Working Example Of The Invention

One working example of the present invention would comprise the specifications of the following components:

For the first circuit for detecting input voltages that are above normal operating voltages:

    1. Transistor 12 is an N-channel MOSFET where the N-channel has a width of 40 micrometers and a length of 3 micrometers.
    2. Transistor 13 is an N-channel MOSFET where the N-channel has a width of 20 micrometers and a length of 3 micrometers.
    3. Transistor 14 is a P-channel MOSFET where the P-channel has a width of 40 micrometers and a length of 3 micrometers.

For the second circuit for activating a time delay circuit:

    1. Transistor 21 is an N-channel MOSFET where the N-channel has a width of 3.5 micrometers and a length of 40 micrometers.
    2. Inverter 22 is a FET inverter where the P-channel transistor has a width of 16 micrometers and a length of 2 micrometers and the N-channel transistor has a width of 8 micrometers and a length of 2 micrometers.

For the third circuit for providing a time delay for distinguishing an undesired input overvoltage from a desired input overvoltage:

    1. Inverter 31 is a FET inverter where the P-channel transistor has a width of 5 micrometers and a length of 20 micrometers and the N-channel transistor has a width of 10 micrometers and a length of 1.3 micrometers.
    2. Capacitor 32 has a width of 40 micrometers and a length of 40 micrometers.

For the fourth circuit for activating the desired mode of the logic device when a desired input overshoot voltage has been detected:

1. Inverter 41 is an FET inverter where the P-channel transistor has a width of 10 micrometers and a length of 2 micrometers and the N-channel transistor has a width of 6 micrometers and a length of 2 micrometers.

2. Inverter 42 is a FET inverter where the P-channel transistor has a width of 40 micrometers and a length of 1.3 micrometers and the N-channel transistor has a width of 20 micrometers and a length of 1.3 micrometers.

The foregoing description of a preferred embodiment and best mode of the invention known to applicant at the time of filing the application has been presented for the purposes of illustration and description. It is not intended to be exhaustive or to limit the invention to the precise form disclosed, and obviously many modifications and variations are possible in the light of the above teaching. The embodiment was chosen and described in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. An apparatus for protecting a programmable logic device from undesired input overshoot voltages comprising:

an input terminal;

a first circuit connected to said input terminal for detecting an input voltage that exceeds a preselected voltage level, said first circuit having an output;

a second circuit having an input connected to the output of the first circuit for activating a time delay circuit, said second circuit having an output;

a third circuit connected to the output of the second circuit for providing a time delay for distinguishing an undesired input overvoltage from a desired input overvoltage, said third circuit having an output; and

a fourth circuit connected to the output of the third circuit for activating the desired mode of the logic device when a desired input overvoltage has been detected.

2. The apparatus for protecting a programmable logic device according to claim 1 wherein the first circuit comprises:

a first circuit component for receiving the input voltage and for detecting when the input voltage level exceeds the preselected voltage level of the device, said first circuit component having an output;

a second circuit component for stabilizing the input of the second circuit when the input voltage is less than the preselected voltage level of the device, said second circuit component having an output; and

a third circuit component coupled to the outputs of the first and second circuit components and which is activated when an input overvoltage is detected.

3. The apparatus for protecting a programmable logic device according to claim 2 wherein:

the first circuit component for receiving the input voltage is an N-Channel MOSFET.

4. The apparatus for protecting a programmable logic device according to claim 2 wherein:

the second circuit component for stabilizing the second circuit is an N-Channel MOSFET.

5. The apparatus for protecting a programmable logic device according to claim 2 wherein:

the third circuit component is a P-Channel MOSFET.

6. The apparatus for protecting a programmable logic device according to claim 1 wherein the second circuit for activating a time delay circuit comprises:

a first circuit component which normally maintains the time delay circuit inactive; and

a second circuit for activating the time delay circuit when an overvoltage is detected.

7. The apparatus for protecting a programmable logic device according to claim 6 wherein:

the first circuit component is an N-Channel MOSFET.

8. The apparatus for protecting a programmable logic device according to claim 6 wherein:

the second circuit comprises a FET inverter.

9. The apparatus for protecting a programmable logic device according to claim 1 wherein the third circuit for providing a time delay is deactivated when an input overvoltage is no longer detected and is reset for reactivation when the next overvoltage is detected.

**10.** The apparatus for protecting a programmable logic device according to claim 1 wherein the third circuit for providing a time delay comprises:

a resistor-capacitor circuit having a predetermined time constant.

**11.** The apparatus for protecting a programmable logic device according to claim 10 wherein the resistor-capacitor circuit comprises:

a FET inverter; and

a capacitor coupled to the output of the inverter.

**12.** The apparatus for protecting a programmable logic device according to claim 10 wherein the resistor portion of the time delay circuit is the resistance in the P-channel transistor of the FET inverter.

**13.** The apparatus for protecting a programmable logic device according to claim 10 wherein the discharge path of the capacitor includes the N-channel transistor of the FET inverter.

**14.** The apparatus for protecting a programmable logic device according to claim 1 wherein the fourth circuit for activating the desired mode of the logic device when a desired input overvoltage has been detected comprises:

a pair of cascade connected inverters.

**15.** The apparatus for protecting a programmable logic device according to claim 14 wherein:

the desired mode of the logic device to be activated is an edit mode of a programmable array.

**16.** An apparatus for protecting a programmable logic device from undesired input overshoot voltages that comprises a time delay circuit.

**17.** An apparatus for protecting a programmable logic device from undesired input overshoot voltages comprising:

a first circuit for detecting an input overvoltage above the level of normal operation of the device; and

a second circuit responsive to the overvoltage for distinguishing between an undesired input overshoot voltage and a desired input programming voltage by activating the desired programmable mode of the logic device only when the overvoltage exceeds a predetermined time delay.

**18.** The apparatus for protecting a programmable logic device according to claim 17 wherein the circuit for distinguishing between an undesired input overshoot voltage and a desired input programming voltage further comprises:

a circuit for delaying the input signal a predetermined interval in a resistive-capacitive time delay circuit.

**19.** The apparatus for protecting a programmable logic device according to claim 18 wherein the delay circuit further comprises:

a circuit for charging the capacitor only when an input overvoltage is detected; and

a circuit for fully discharging the capacitor when an input overvoltage is suddenly not detected.

**20.** A method for protecting a programmable logic device from undesired input overshoot voltages comprising the steps of:

detecting an input overvoltage above the level of normal operation of the device; and

distinguishing between an undesired input overshoot voltage and a desired input programming voltage by activating the desired programmable mode of the logic device only when the overvoltage exceeds a predetermined time delay.

**21.** The method for protecting a programmable logic device according to claim 20 wherein the step of detecting a voltage above the level of normal operation further comprises the step of:

stabilizing the detecting circuit input during normal operations.

**22.** The method for protecting a programmable logic device according to claim 20 wherein the step of detecting a voltage level above the level of normal operation further comprises the step of:

providing a signal that will activate the time delay only when an input overvoltage is detected.

**23.** The method for protecting a programmable logic device according to claim 20 wherein the step of distinguishing between an undesired input overshoot voltage and a desired input programming voltage further comprises the step of:

delaying the input signal a predetermined interval in a resistive-capacitive time delay circuit.

**24.** The method for protecting a programmable logic device according to claim 23 wherein the delaying step further comprises the step of:

charging the capacitor only when an input overvoltage is detected; and

fully discharging the capacitor when an input overvoltage is suddenly not detected.

EP 0 598 475 A2

```
        ┌──────────────┐      ┌──────────────┐      ┌──────────────┐      ┌──────────────┐
        │  DETECTING   │      │  ACTIVATING  │      │              │      │  ACTIVATING  │
        │VOLTAGE ABOVE │ ───▶ │ A TIME DELAY │ ───▶ │  PROVIDING   │ ───▶ │ THE DESIRED  │
        │ PRESELECTED  │      │   CIRCUIT    │      │ A TIME DELAY │      │  MODE OR THE │
        │    LEVEL     │      │              │      │              │      │ LOGIC DEVICE │
        └──────────────┘      └──────────────┘      └──────────────┘      └──────────────┘
              10'                   20'                   30'                   40'
```

*Fig. 1*

Fig. 2